# DEMANDE DE BREVET EUROPEEN

(11) **EP 4 822 449 A1**
(43) Date de publication de la demande: **14.10.2026**
(21) Numéro de dépôt: 26168277.7
(22) Date de dépôt: 26.03.2026
(51) Int. Cl.: G04B 1/14, B81C 1/00, B81C 99/00, G04B 13/02, G04B 15/14, G04B 17/06, G04B 19/04, G04D 3/00

(54) **PROCEDE DE FABRICATION DE COMPOSANTS HORLOGERS EN SILICIUM**

(30) Priorité: 10.04.2025 EP 25169753; 15.09.2025 EP 25202147
(71) Demandeur: Richemont International S.A., 1752 Villars-sur-Glâne (CH)
(72) Inventeur: COLLET, Garance, 31380 Azas (FR); DEMOLON, Pierre, 2023 Gorgier (CH); MONTINARO, Enrica, 3012 Berne (CH); CHABART, Mickaël, 2014 Fleurier (CH)
(74) Mandataire: Novagraaf International SA

(57) **Abrégé**

L'invention concerne un procédé de fabrication d'au moins un composant horloger (1000) comprenant au moins une première portion d'une première largeur et au moins une deuxième portion d'une deuxième largeur, le procédé de fabrication comprenant au moins les étapes consistant à :
i- graver le composant horloger (1000),
ii- former un espace libre au moins en dessous de la première portion du composant horloger (1000),
caractérisé :
en ce que l'étape i- comprend une étape consistant à graver dans la première portion un trou de passage (15 ; 15-1, 15-2) traversant la couche de travail (10),
et en ce que l'étape ii- comprend l'exposition et la gravure de ladite au moins une des autres couches par un agent de gravure passant au travers du trou de passage (15 ; 15-1, 15-2).

## Description

### Domaine technique de l'invention

La présente invention concerne de manière générale la fabrication de composants horlogers en silicium, et en particulier, la présente invention concerne de manière générale la fabrication de composants horlogers en silicium à partir d'une plaquette multicouches, comme une plaquette de type SOI (Silicon On Insulator), comprenant une couche de travail dans laquelle on grave les composants horlogers, au moins une couche de support et au moins une couche enterrée (par exemple en oxyde de silicium) agencée entre la couche de travail et la couche de support.

### État de la technique

La fabrication de composants horlogers en silicium tels que (de façon non limitative) des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage par gravure dans une plaquette en silicium. Les procédés de réalisation de ces composants horlogers utilisent généralement des plaquettes de silicium monocristallin, mais des plaquettes en silicium polycristallin ou amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde SiO2 sur le composant. Quand les composants horlogers sont réalisés à partir d'une plaquette en silicium monocristallin, l'une quelconque des trois orientations cristallines <100>, <110> ou <111> peut être utilisée.

Les plaquettes de silicium sont proposées sous forme de galette simple, par exemple des wafers de type SSP (« Single Side polished » en anglais) ou de type DSP (« Dual Side Polished » en anglais). Le document EP3495894 décrit un procédé de fabrication de composants horlogers en silicium utilisant une telle plaquette comprenant une couche simple en silicium sans couche de support. Selon ce document, la plaquette simple a une épaisseur sensiblement égale à l'épaisseur maximale des composants horlogers à fabriquer, et pour former les composants horlogers, on effectue une étape de gravure dans toute l'épaisseur de la plaquette, la totalité du matériau du composant présent dans la plaquette étant ainsi utilisée pour former les composants horlogers, sans fonction de support dans la plaquette. Après leur formation, les composants horlogers ne sont supportés structurellement que par des ponts de liaison fins qui les maintiennent attachés aux parties subsistantes de la couche simple en silicium, et il est possible d'effectuer des étapes de fabrication subséquentes sur la quasi-totalité de la surface externe des composants sans qu'il soit nécessaire d'effectuer une étape de libération des composants auparavant. Cependant, dans le procédé de fabrication du document EP3495894, l'étape de gravure est délicate car elle a lieu dans une plaquette relativement mince, et donc fragile, sans aucun support.

Alternativement, les plaquettes SOI (« silicon-on-insulator » en anglais) sont souvent utilisées pour la fabrication de composants horlogers. Une plaquette SOI comprend une couche de travail en silicium (la couche « device » en anglais) dans laquelle les composants horlogers sont fabriqués, une couche de support en silicium qui sert de substrat ou de support lors de la fabrication des composants (la couche « handle » en anglais), et une couche d'oxyde enterrée en SiO2 qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail d'une plaquette SOI, les composants sont normalement libérés de la couche de support et de la couche d'oxyde enterrée de la plaquette SOI afin de faciliter des étapes de fabrication subséquentes. Cette étape de libération nécessite d'éliminer (typiquement par gravure ou attaque chimique) la couche d'oxyde enterrée de la plaquette SOI et/ou partiellement la couche de support de la plaquette SOI sous les composants horlogers. De telles opérations d'élimination peuvent être longues et affecter des parties fines des composants horlogers, qui seront complétement libérées avant des parties plus larges (en vue de dessus). Les parties fines (et éventuellement leur couche de protection) sont donc exposées plus longtemps à l'agent de gravure et peuvent être négativement affectées (perte de matière, exposition thermique, déformations...). A titre d'exemple, un spiral horloger en silicium présente typiquement en vue de dessus une partie très fine (le barreau formant la partie élastique en spirale) et des parties plus larges comme la partie centrale et/ou l'extrémité libre de pitonnage : il faut donc garantir que la libération de ces parties larges n'affecte pas les parties plus fines.

Après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur quasiment l'ensemble de la surface externe des composants de la plaquette.

Les étapes subséquentes peuvent notamment comprendre des étapes d'oxydation et désoxydation pour le lissage des surfaces des composants. Les étapes subséquentes peuvent également comprendre des étapes d'oxydation et désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique. Après ces étapes subséquentes, les composants horlogers peuvent être détachés de la plaquette et montés dans par exemple le mouvement d'une pièce d'horlogerie.

Le document CH721138A1 divulgue un procédé de fabrication de composants horlogers en silicium. Le document US20060055097A1 divulgue un spiral horloger pour un oscillateur et sa méthode de fabrication.

Il serait alors avantageux d'avoir un procédé de fabrication de composants horlogers en silicium comprenant des étapes de libération des composants qui sont moins longues, plus efficaces et qui permettent de garantir que même les parties les plus fines des composants horlogers ne sont pas affectées par ces étapes de libération.

### Exposé de l'invention

Un but de la présente invention est de répondre aux inconvénients de l'art antérieur mentionnés ci-dessus et en particulier, tout d'abord, de proposer un procédé de fabrication d'au moins un composant horloger en silicium dans une couche de travail d'une plaquette multicouches, le composant horloger comprenant au moins une partie fine et au moins une partie plus large en vue de dessus, le procédé comprenant au moins une étape consistant à former un espace libre au moins en dessous de la partie large du composant horloger en gravant au moins une des autres couches de la plaquette multicouches, tout en garantissant de ne pas affecter négativement la partie fine du composant horloger.

Pour cela un premier aspect de l'invention concerne un procédé de fabrication d'au moins un composant horloger en silicium dans une couche de travail d'une plaquette multicouches, le composant horloger comprenant, en vue de dessus, au moins une première portion, dite large, d'une première largeur et au moins une deuxième portion, dite fine, d'une deuxième largeur, avec la deuxième largeur inférieure à 30%, ou 35%, ou 40%, ou 45%, ou 50%, ou 55%, ou 60% de la première largeur, le procédé de fabrication comprenant au moins les étapes consistant à :
i- graver le composant horloger dans la couche de travail,
ii- former un espace libre (ou une cavité) au moins en dessous de la première portion du composant horloger en gravant au moins une des autres couches de la plaquette multicouches,
   caractérisé :
   en ce que l'étape i- comprend une étape consistant à graver dans la première portion un trou de passage traversant la couche de travail, de préférence mais pas forcément en même temps que la gravure du composant horloger dans la couche de travail,
   et en ce que l'étape ii- comprend l'exposition et la gravure de ladite au moins une des autres couches par un agent de gravure passant au travers du trou de passage,
   dans lequel la présence du trou de passage permet de garantir que l'étape ii-peut être totalement réalisée dans un temps strictement inférieur à un temps nécessaire pour former un espace libre sous une portion de la couche de travail présentant la première largeur.

Selon la mise en œuvre ci-dessus, le composant horloger comprend une portion fine (typiquement la portion la plus fine du composant horloger) et une portion large (typiquement la portion la plus large du composant horloger) en vue de dessus. On comprend que la formation de l'espace libre (ou de la cavité) sous la portion large devrait nécessiter un temps plus important que pour former l'espace libre (ou la cavité) sous la portion fine. Typiquement, le temps de formation de l'espace libre sous la portion large est plus important que le temps pour former l'espace libre sous la portion fine (ce temps dépend de la largeur à graver en sous couche, et le temps de gravure peut être une fonction linéaire ou une fonction non linéaire en fonction de la largeur à graver). Pour limiter le temps total de formation de l'espace libre sous la portion large, le procédé de fabrication comprend une étape préalable consistant à former un trou de passage dans la portion large, pour permettre de former l'espace libre sous la portion large en faisant passer l'agent de gravure au travers du trou de passage. Ainsi, la formation de l'espace libre sous la portion large du composant (ou entre les bords du composant) se fait depuis le trou de passage ainsi que depuis les bords latéraux de la portion large, et pas uniquement depuis les bords latéraux de la portion large. Si le trou de passage est prévu au milieu de la portion large, alors le temps de formation de l'espace libre sous la portion large est plus court, et peut être globalement réduit par rapport à un composant horloger similaire sans trou de passage, avec par exemple un temps de gravure qui peut être divisé par deux environ (étant entendu que la réduction du temps de gravure est fonction de la largeur à graver la sous couche, et que le temps de gravure peut ne pas être linéaire avec la largeur à graver).

On entend par espace libre une ou plusieurs cavités formées par la gravure sous le composant horloger. En particulier, la sous-gravure, pour effectuer la libération du composant horloger, retire la matière d'une sous-couche de la plaquette en formant des espaces libres ou des cavités sous le composant horloger, qui se trouve donc libéré à des endroits.

Selon un mode de réalisation, le trou de passage est de forme circulaire. Selon un mode de réalisation, le trou de passage est de forme allongée, oblongue, linéaire. Selon un mode de réalisation, le trou de passage est de forme quelconque. Selon un mode de réalisation, le trou de passage présente une forme qui suit un bord du composant à distance régulière ou prédéterminée. Selon un mode de réalisation, le trou de passage présente un profil fermé, en particulier en vue de dessus.

Selon un mode de réalisation et par exemple, pour un spiral horloger, la portion fine peut être le barreau formé en spirale, et la portion large peut être la partie centrale munie d'un trou pour se monter sur un arbre de balancier. Selon un mode de réalisation et par exemple, pour une roue d'échappement, la portion fine peut être une dent ou un bras reliant une couronne périphérique dentée à un moyeu central, et la portion large peut être le moyeu central. Selon un mode de réalisation et par exemple, pour un balancier, la portion fine peut être un bras reliant une serge périphérique à un moyeu central, et la portion large peut être le moyeu central. Bien entendu, le mode de réalisation concernant un spiral n'est qu'un exemple et la méthode peut être appliquée à tout composant présentant des parties dont la largeur, en vue de dessus, n'est pas la même et présente en particulier des différences notables (au moins 30%, au moins 40%, au moins 50% de différence de largeur).

Le procédé de fabrication peut comprendre les caractéristiques suivantes, prises individuellement ou en combinaison.

Selon un mode de réalisation, le trou de passage est non-fonctionnel une fois le composant horloger assemblé dans une pièce d'horlogerie. En particulier, on peut prévoir que le trou de passage n'a aucune influence sur le fonctionnement du composant horloger une fois monté dans une pièce d'horlogerie. Typiquement, le trou de passage est prévu uniquement pour permettre une gravure rapide sous la portion large du composant horloger. Selon un mode de réalisation, le trou de passage ne reçoit aucun autre composant horloger ou ne coopère mécaniquement avec aucun autre composant horloger de la pièce d'horlogerie. Typiquement, le trou de passage est prévu pour ne modifier aucune caractéristique du composant horloger, en comparaison avec un composant horloger similaire sans trou de passage.

Selon un mode de réalisation, le procédé de fabrication peut comprendre une étape consistant à vérifier que le trou de passage ne modifie aucune caractéristique du composant horloger au-delà d'un seuil prédéterminé, en comparaison avec un composant horloger similaire sans trou de passage. Selon un mode de réalisation, le trou de passage ne modifie aucune caractéristique de fonctionnement affectant la marche de la pièce d'horlogerie, en particulier le trou de passage ne modifie pas les performances chronométriques. Selon un mode de réalisation, le trou de passage ne modifie aucune caractéristique de fonctionnement affectant la tenue mécanique du composant horloger, en comparaison avec un composant horloger similaire sans trou de passage. Selon un mode de réalisation, le trou de passage ne modifie aucune caractéristique de montage ou d'assemblage du composant horloger dans la pièce d'horlogerie, en comparaison avec un composant horloger similaire sans trou de passage.

Selon un mode de réalisation, la gravure du trou de passage est réalisée de sorte à former au moins une troisième portion d'une troisième largeur supérieure à la deuxième largeur, et de préférence la gravure du trou de passage conduit à former deux troisièmes portions d'une troisième largeur supérieure à la deuxième largeur. Selon ce mode de réalisation, la gravure du trou de passage conduit à segmenter ou diviser la largeur de la portion large, pour obtenir des parois moins larges. Selon ce mode de réalisation, la gravure du trou de passage conduit à former un quadrillage ou un schéma de parois intermédiaires dans la portion large pour garantir un temps de formation de l'espace libre plus court que pour un composant horloger similaire sans trou de passage. Autrement dit, la gravure du trou de passage est réalisée de sorte à réduire la surface ou la portion la plus large en deux surfaces ou deux portions plus étroites.

Selon un mode de réalisation, la troisième largeur est supérieure d'au moins 10%, ou 15%, ou 20%, ou 25% à la deuxième largeur. Ainsi, les troisièmes portions restent plus rigides que la deuxième portion : le comportement mécanique du composant horloger dans la pièce d'horlogerie n'est pas affecté, en comparaison avec un composant horloger similaire sans trou de passage.

Selon un mode de réalisation, la plaquette multicouches comprend au moins une couche support par exemple en silicium, et une couche enterrée en oxyde de silicium sépare la couche de travail et la couche support, et l'étape ii- comprend la gravure de la couche enterrée, par exemple avec une solution d'acide fluorhydrique (HF) ou avec de l'acide fluorhydrique (HF) en vapeur, ou avec du gaz HF anhydre.

Selon un mode de réalisation, la plaquette multicouches comprend au moins une couche enterrée en graphène ou en silicium, ou comprenant un métal (par exemple du chrome), et l'étape ii- comprend la gravure de la couche enterrée.

Selon un mode de réalisation, la plaquette multicouches comprend au moins une couche support en silicium, et une couche enterrée par exemple en oxyde de silicium sépare la couche de travail et la couche support, et l'étape ii- comprend la gravure de la couche support, avec par exemple :
- une gravure isotrope utilisant un plasma à base d'hexafluorure de soufre (SF6), ou
- une gravure isotrope en phase vapeur à base de difluorure de xénon (XeF2), ou
- une gravure humide anisotrope utilisant un bain d'hydroxyde de potassium (KOH) ou un bain de d'hydroxyde de tétraméthylammonium (TMAH).

Selon un mode de réalisation, le procédé de fabrication comprend une étape intermédiaire entre les étapes i- et ii- consistant à recouvrir au moins le composant gravé avec une couche de protection, procurant une protection du composant horloger lors de la gravure de l'étape ii-. La couche de protection peut être formée avec de l'oxyde de silicium formé par oxydation thermique ou déposé par PVD ou CVD, ou encore du nitrure de silicium (SiN) déposé par PVD ou CVD ou dans un four de nitruration, avec une résine, avec un polymère initialement dissous dans un solvant sous forme d'un vernis, avec du C4F8 (Octafluorocyclobutane) injecté dans un plasma pour former un film polymérique fluorocarboné.

Selon un mode de réalisation, le procédé de fabrication comprend les étapes initiales consistant à :
- identifier ladite au moins une première portion et ladite au moins une deuxième portion,
- prévoir et implanter le trou de passage dans la première portion.

Ainsi, le procédé global peut être une méthode de fabrication d'un composant horloger en silicium à fabriquer dans une couche de travail d'une plaquette multicouches, comprenant :
- une phase de conception du composant horloger en silicium comprenant :
   - l'identification, typiquement dans une vue de dessus du composant horloger, d'au moins une première portion, dite large, d'une première largeur et d'au moins une deuxième portion, dite fine, d'une deuxième largeur, avec la deuxième largeur inférieure à 30%, ou 35%, ou 40%, ou 45%, ou 50%, ou 55%, ou 60% de la première largeur,
   - l'implantation d'un trou de passage dans la première portion,
- une phase de fabrication dudit composant horloger en silicium dans une couche de travail d'une plaquette multicouches, comprenant au moins les étapes consistant à :
   i- graver le composant horloger dans la couche de travail,
   ii- former un espace libre (ou une cavité) au moins en dessous de la première portion du composant horloger en gravant au moins une des autres couches de la plaquette multicouches,
      caractérisé :
      en ce que l'étape i- comprend une étape consistant à graver dans la première portion le trou de passage traversant la couche de travail, de préférence mais pas forcément en même temps que la gravure du composant horloger dans la couche de travail,
      et en ce que l'étape ii- comprend l'exposition et la gravure de ladite au moins une des autres couches par un agent de gravure passant au travers du trou de passage,
      dans laquelle, la présence du trou de passage permet de garantir que l'étape ii- peut être totalement réalisée dans un temps strictement inférieur à un temps nécessaire pour former un espace libre sous une portion de la couche de travail présentant la première largeur et dépourvue de trou de passage.

Selon un mode de réalisation, l'étape consistant à prévoir et implanter le trou de passage comprend au moins les étapes suivantes :
- une optimisation consistant à trouver la plus grande surface possible du trou de passage, et/ou
- une vérification du fonctionnement d'une pièce d'horlogerie comprenant le composant horloger avec le trou de passage, dans une plage de fonctionnement attendue et prédéterminée. Typiquement, on peut prévoir de vérifier que la présence du trou de passage n'affecte pas les caractéristiques mécaniques du composant horloger (en particulier son montage et sa tenue dans la pièce d'horlogerie), ni les caractéristiques de fonctionnement de la pièce d'horlogerie (par exemple la marche de la pièce d'horlogerie ou la chronométrie).

Selon un mode de réalisation, le composant horloger est un spiral horloger, et l'étape de vérification du fonctionnement comprend la vérification que :
- la raideur du spiral horloger, et/ou la résistance aux chocs et/ou l'isochronisme de la pièce d'horlogerie comprenant le spiral horloger avec le trou de passage, ne varient pas au-delà d'un pourcentage prédéterminé par rapport à respectivement la raideur du spiral horloger, et/ou à l'isochronisme de la pièce d'horlogerie comprenant un spiral horloger sans le trou de passage,
- le spiral horloger avec le trou de passage peut être accouplé à une virole sans déformation irréversible. Selon un mode de réalisation, et en ce qui concerne la raideur, le pourcentage prédéterminé à ne pas dépasser peut être de 0,05%, de préférence 0,04%, de préférence 0,03%, de préférence 0,02%, de préférence 0,01% de la raideur du spiral horloger sans le trou de passage. Selon un mode de réalisation, et en ce qui concerne l'isochronisme et en particulier la marche à 200° en s/j, le pourcentage prédéterminé à ne pas dépasser peut être de 15%, de préférence 12%, de préférence 10% de la marche avec un spiral horloger sans le trou de passage. Selon un mode de réalisation, et en ce qui concerne les contraintes mécaniques causées par des oscillations ou par l'accouplement sur un arbre de balancier, le pourcentage prédéterminé à ne pas dépasser peut être de 15%, de préférence 12%, de préférence 8%, de préférence 6%, de préférence 5% des contraintes mécaniques dans le spiral horloger sans le trou de passage causées par des oscillations ou par l'accouplement sur un arbre de balancier.

Selon un mode de réalisation, la deuxième portion présente une largeur inférieure à 110 µm, de préférence 100 µm, de préférence 90 µm, de préférence 80 µm, et/ou la première portion comprend une largeur supérieure à 120 µm, de préférence 130 µm, de préférence 140 µm.

Selon un mode de réalisation, chaque première portion du composant horloger est gravée avec au moins un trou de passage. Selon ce mode de réalisation, le composant horloger est désormais exempt de paroi ayant la première largeur. Toutes les parois ayant la première largeur avant la gravure dudit au moins un trou de passage sont segmentées ou partitionnées pour présenter une largeur inférieure à la première largeur, pour garantir un temps de formation de l'espace libre sous les portions en question plus court en comparaison avec un composant horloger similaire sans trou de passage.

Selon un mode de réalisation :
- l'étape i- comprend au moins une étape de formation d'un masque de gravure, typiquement par photolithographie, et/ou au moins une étape de gravure ionique réactive profonde,
- l'étape i- conduit à graver au moins un pont de liaison entre le composant horloger et le reste de la couche de travail,
- l'étape ii- est suivie par une étape de libération du composant horloger de la couche de travail (en effectuant une gravure sous le composant horloger),
- au moins une étape d'oxydation et/ou de désoxydation du composant horloger est réalisée, de préférence après la formation de l'espace libre (c'est-à-dire après la libération du composant horloger).

Un deuxième aspect de l'invention se rapporte à un spiral horloger en silicium, comprenant :
- une partie centrale avec une ouverture centrale pour se monter sur un arbre de balancier,
- un barreau formé en spirale,
- une extrémité libre, de pitonnage ou de collage, et/ou un point d'attache au reste de la plaquette,
dans lequel la partie centrale, et l'extrémité libre, de pitonnage ou de collage, et/ou le point d'attache au reste de la plaquette, le cas échéant, présente une première portion avec une première largeur,
- le barreau formé en spirale présente une deuxième portion avec une deuxième largeur,
   la deuxième largeur est inférieure à 60%, de préférence 50%, de préférence 45% de la première largeur,
   caractérisé en ce que la partie centrale, et/ou l'extrémité libre, de pitonnage ou de collage, et/ou le point d'attache au reste de la plaquette, le cas échéant, comprend au moins un trou de passage de sorte à ce que la partie centrale, et/ou l'extrémité libre, de pitonnage ou de collage, et/ou le point d'attache au reste de la plaquette, le cas échéant, soit exempt de paroi d'une largeur supérieure à 2,5 fois, de préférence 2 fois, de préférence à 1,8 fois ou 1,65 fois,1,5 fois, 1,4 fois ou 1,3 ou même 1,1 fois, la deuxième largeur. Un tel spiral ayant la première portion pourvue d'au moins un trou de passage peut être fabriqué dans une plaquette multicouches en minimisant les risques de défauts sur le barreau (notamment un enlèvement de matière et/ou des déformations intempestifs) pour former un espace libre sous le spiral encore attaché à la couche de travail, afin de pouvoir par exemple effectuer des étapes d'oxydation et/ou de désoxydation sur tout le spiral.

Dans la présente demande, la partie centrale du spiral représente toute la partie destinée à être fixée, attachée, chassée sur l'arbre de balancier, de manière directe ou indirecte (via par exemple une douille ou une virole rapportée). En d'autres termes, la partie centrale est le moyeu à partir duquel le barreau en spirale démarre ou s'étend. La partie centrale englobe ou désigne l'entièreté de la partie centrale de matière qui raccorde le barreau en spirale avec le trou central de fixation à l'arbre de balancier.

On entend par largeur d'une paroi (ou épaisseur en vue de dessus ou dessous), la distance qui sépare deux faces de la paroi, selon une direction normale ou sensiblement normale à une direction longitudinale de la paroi.

En particulier pour une première alternative, le deuxième aspect de l'invention peut se rapporter à un spiral horloger en silicium, comprenant :
- une partie centrale avec une ouverture centrale pour se monter sur un arbre de balancier,
- un barreau formé en spirale,
dans lequel la partie centrale, présente une première portion avec une première largeur,
- le barreau formé en spirale présente une deuxième portion avec une deuxième largeur,

la deuxième largeur est inférieure à 60%, de préférence 50%, de préférence 45% de la première largeur,
caractérisé en ce que la partie centrale comprend au moins un trou de passage de sorte à ce que la partie centrale soit exempte de paroi d'une largeur supérieure à 2,5 fois, de préférence 2 fois, de préférence à 1,8 fois ou 1,65 fois,1,5 fois, 1,4 fois ou 1,3 ou même 1,1 fois, la deuxième largeur.

Autrement dit, le spiral horloger en silicium comprend :
- une partie centrale avec une ouverture centrale pour se monter sur un arbre de balancier,
- un barreau formé en spirale,
dans lequel la partie centrale, présente une première portion avec une première largeur,
- le barreau formé en spirale présente une deuxième portion avec une deuxième largeur,

la deuxième largeur est inférieure à 60%, de préférence 50%, de préférence 45% de la première largeur,
caractérisé en ce que la partie centrale comprend au moins un trou de passage de sorte à ce que toutes les parois de la partie centrale présentent une largeur inférieure à 2,5 fois, de préférence 2 fois, de préférence à 1,8 fois ou 1,65 fois,1,5 fois, 1,4 fois ou 1,3 ou même 1,1 fois, la deuxième largeur.

En particulier pour une deuxième alternative, le deuxième aspect de l'invention peut se rapporter à un spiral horloger en silicium, comprenant :
- une partie centrale avec une ouverture centrale pour se monter sur un arbre de balancier,
- un barreau formé en spirale,
- une extrémité libre, de pitonnage ou de collage, et/ou un point d'attache au reste de la plaquette,
dans lequel l'extrémité libre, de pitonnage ou de collage, et/ou le point d'attache au reste de la plaquette présente une première portion avec une première largeur,
- le barreau formé en spirale présente une deuxième portion avec une deuxième largeur,

la deuxième largeur est inférieure à 60%, de préférence 50%, de préférence 45% de la première largeur,
caractérisé en ce que l'extrémité libre, de pitonnage ou de collage, et/ou le point d'attache au reste de la plaquette comprend au moins un trou de passage de sorte à ce que l'extrémité libre, de pitonnage ou de collage, et/ou le point d'attache au reste de la plaquette soit exempt de paroi d'une largeur supérieure à 2,5 fois, de préférence 2 fois, de préférence à 1,8 fois ou 1,65 fois,1,5 fois, 1,4 fois ou 1,3 ou même 1,1 fois, la deuxième largeur.

Autrement dit, le deuxième aspect de l'invention peut se rapporter à un spiral horloger en silicium, comprenant :
- une partie centrale avec une ouverture centrale pour se monter sur un arbre de balancier,
- un barreau formé en spirale,
- une extrémité libre, de pitonnage ou de collage, et/ou un point d'attache au reste de la plaquette,
dans lequel l'extrémité libre, de pitonnage ou de collage, et/ou le point d'attache au reste de la plaquette présente une première portion avec une première largeur,
- le barreau formé en spirale présente une deuxième portion avec une deuxième largeur,

la deuxième largeur est inférieure à 60%, de préférence 50%, de préférence 45% de la première largeur,
caractérisé en ce que l'extrémité libre, de pitonnage ou de collage, et/ou le point d'attache au reste de la plaquette comprend au moins un trou de passage de sorte à ce que toutes les parois de l'extrémité libre, de pitonnage ou de collage, et/ou du point d'attache au reste de la plaquette présentent une largeur inférieure à 2,5 fois, de préférence 2 fois, de préférence à 1,8 fois ou 1,65 fois,1,5 fois, 1,4 fois ou 1,3 ou même 1,1 fois, la deuxième largeur.

Selon un mode de réalisation, ledit au moins un trou de passage est prévu pour former un réseau de parois dans la première portion. Chacune des parois de ce réseau de parois respecte la condition d'avoir une largeur inférieure à 2,5 fois, de préférence 2 fois, de préférence à 1,8 fois ou 1,65 fois,1,5 fois, 1,4 fois ou 1,3 ou même 1,1 fois, la deuxième largeur

Selon un mode de réalisation, la partie centrale comprend un trou central prévu pour recevoir, directement ou indirectement, un axe ou un arbre de balancier. Selon un mode de réalisation, le trou central présente une forme polygonale, ou circulaire. Selon un mode de réalisation, le trou central présente une forme octogonale.

Selon un mode de réalisation, le barreau formé en spirale présente une deuxième portion avec une deuxième largeur comprise entre 80 µm et 20 µm, de préférence entre 70 µm et 30 µm.

Selon un mode de réalisation, le barreau formé en spirale peut présenter une partie dite épaisse (par exemple la première spire en partant du centre) avec la deuxième largeur comprise entre 80 µm et 70 µm, ou entre 70 µm et 60 µm, ou entre 60 µm et 50 µm, ou entre 50 µm et 40 µm, ou entre 40 µm et 30 µm, ou entre 30 µm et 20 µm.

Selon un mode de réalisation, le barreau formé en spirale peut présenter une deuxième largeur comprise entre 80 µm et 20 µm, ou entre 80 µm et 60 µm, ou entre 70 µm et 60 µm, ou entre 60 µm et 50 µm, ou entre 50 µm et 40 µm, ou entre 40 µm et 30 µm, ou entre 30 µm et 20 µm.

Selon un mode de réalisation, toutes les parois de la partie centrale présentent une largeur inférieure à 120 µm, de préférence inférieure à 110 µm, de préférence inférieure à 100 µm, de préférence inférieure à 90 µm, de préférence inférieure à 80 µm, de préférence inférieure à 70 µm, de préférence inférieure à 60 µm.

Selon un mode de réalisation, toutes les parois de l'extrémité libre, de pitonnage ou de collage, et/ou du point d'attache au reste de la plaquette présentent une largeur inférieure à 120 µm, de préférence inférieure à 110 µm, de préférence inférieure à 100 µm, de préférence inférieure à 90 µm, de préférence inférieure à 80 µm, de préférence inférieure à 70 µm, de préférence inférieure à 60 µm.

Selon un mode de réalisation, le trou de passage est agencé (en forme ou en position) pour que tout point de la partie centrale, situé sur la surface inférieure ou supérieure du spiral, soit éloigné d'un bord de la partie centrale d'une distance qui n'excède pas 2,5 fois, de préférence 2 fois, de préférence à 1,8 fois ou 1,65 fois,1,5 fois, 1,4 fois ou 1,3 ou même 1,1 fois, la deuxième largeur.

Selon un mode de réalisation, le trou de passage est agencé (en forme ou en position) pour que tout point de la partie centrale, situé sur la surface inférieure ou supérieure du spiral, soit éloigné d'un bord de la partie centrale d'une distance qui n'excède pas 150 µm, de préférence 120 µm, de préférence 100 µm, de préférence 90 µm, de préférence inférieure 80 µm, de préférence 70 µm, de préférence 60 µm, de préférence 50 µm, de préférence 40 µm.

Selon un mode de réalisation, la partie centrale comprend une pluralité de trous de passage. Selon un mode de réalisation, la partie centrale comprend au moins trois trous de passage, au moins quatre trous de passage, au moins cinq trous de passage.

Selon un mode de réalisation, la partie centrale comprend un trou central polygonal, et la portion centrale un nombre de trous de passage égal au nombre de côtés du polygone, à plus ou moins un trou près. Ainsi, les trous de passage sont bien répartis autour du trou central.

### Description des figures

D'autres caractéristiques et avantages de la présente invention apparaîtront plus clairement à la lecture de la description détaillée qui suit de mode(s) de réalisation de l'invention donné(s) à titre d'exemple(s) nullement limitatif(s) et illustré(s) par les dessins annexés, dans lesquels :
Les figures 1a à 1c, 1e à 1m et 1o représentent des étapes de fabrication d'un composant horloger en silicium dans une plaquette multicouches, avec la figure 1e qui représente en particulier une étape d'irradiation ou d'exposition à un rayonnement d'une couche de résine pour effectuer une photolithographie avant une gravure pour former le composant horloger selon l'invention, avec un trou de passage dans une portion large, et la figure 1m qui représente une étape de formation d'un espace libre sous le composant horloger (c'est-à-dire une sous-gravure en vue d'une libération) ;
La figure 1d représente la même étape d'irradiation ou d'exposition à un rayonnement que la figure 1e, et la figure 1n représente la même étape de début de libération du composant horloger en gravant la couche de support de silicium avec la formation d'un espace libre sous le composant horloger que la figure 1m mais ces deux figures sont relatives à la fabrication d'un composant horloger de l'art antérieur, sans trou de passage ;
La figure 1p représente, après libération un espace libre formé sous un composant horloger fabriqué dans une couche de travail d'une plaquette comprenant deux couches enterrées et deux couches de support sous la couche de travail ;
La figure 2 représente une vue partielle de dessus d'une première variante de réalisation d'un composant horloger comprenant une portion large avec un trou de passage ;
La figure 3 représente une vue partielle de dessus d'une deuxième variante de réalisation d'un composant horloger comprenant une portion large avec plusieurs trous de passage.

### Description détaillée de mode(s) de réalisation

Dans tout ce qui suit, les orientations sont les orientations des figures. En particulier, les termes comme « supérieur », « inférieur », « gauche », « droit », « dessus », « dessous », « horizontal », « latéral », « vertical », « vers l'avant » et « vers l'arrière » s'entendent généralement par rapport au sens de représentation des figures. Les figures sont schématiques et peuvent présenter des proportions et/ou des aspects différents de la réalité même au sein d'une même figure, mais illustrent à tout le moins le déroulement et/ou les étapes des procédés décrits.

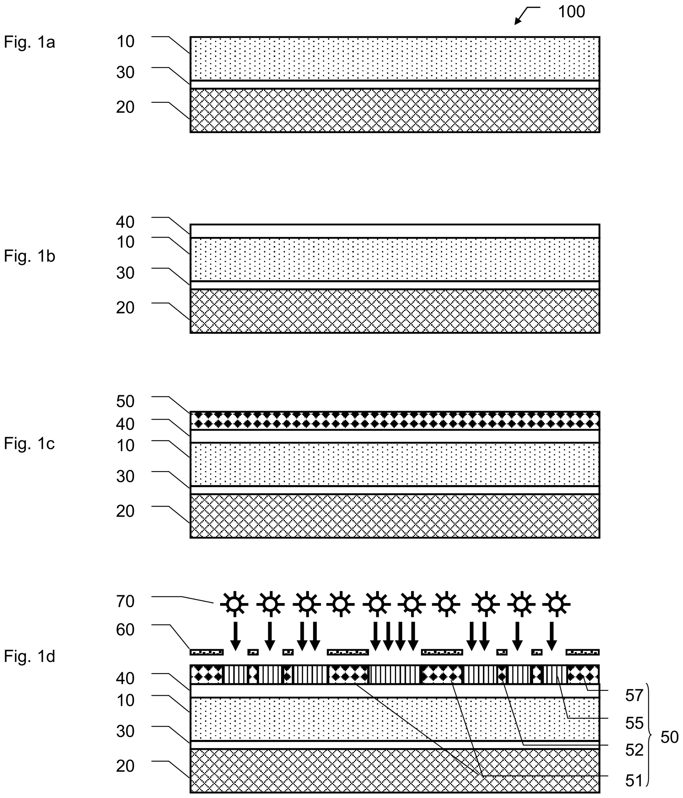

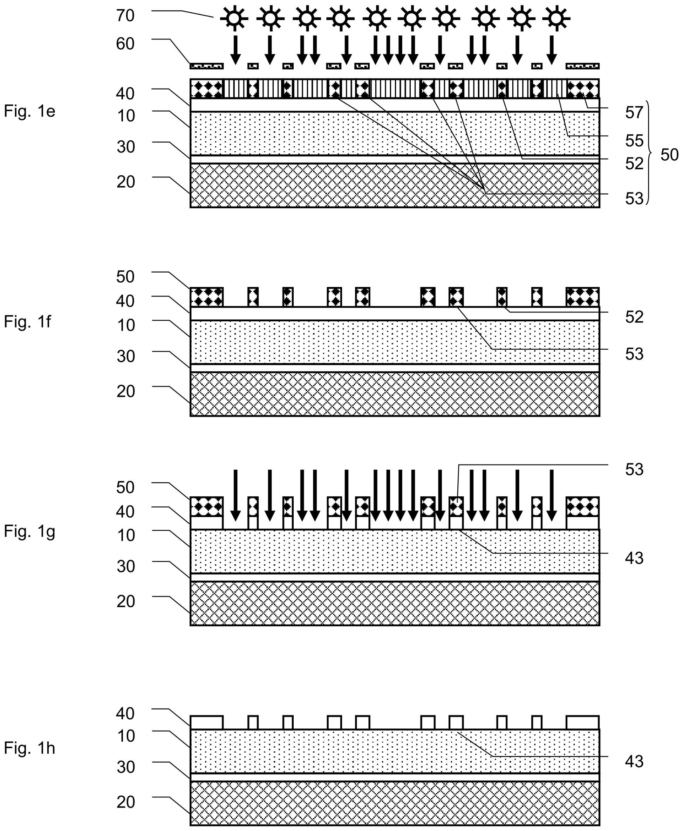

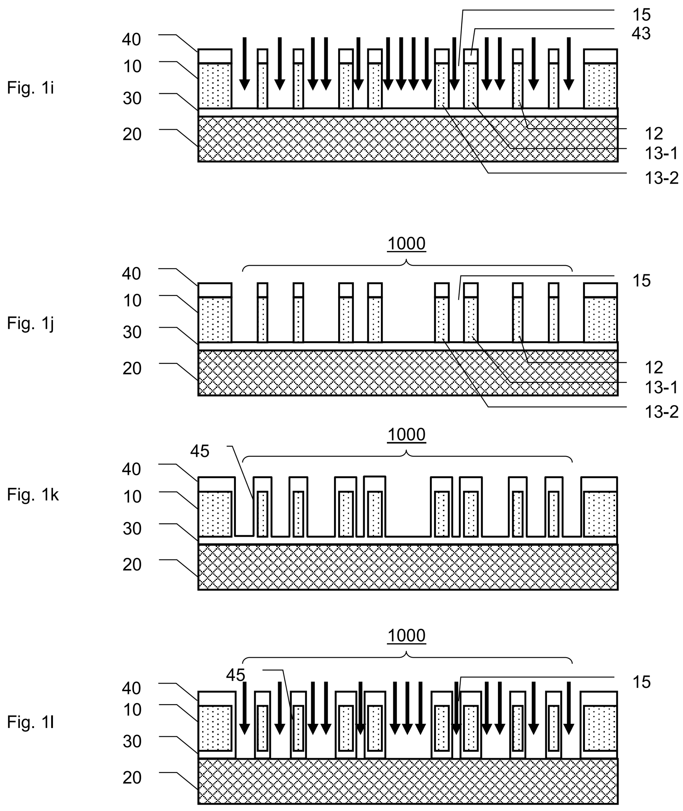

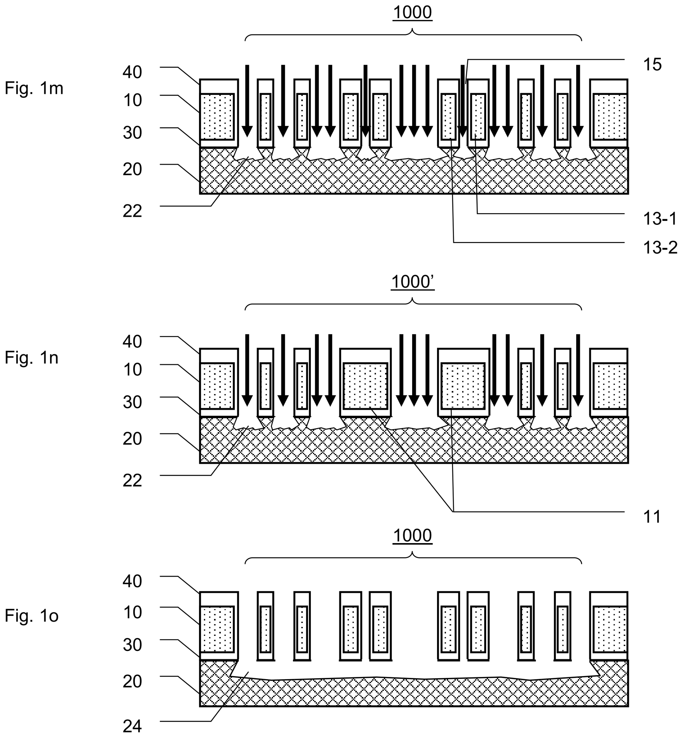

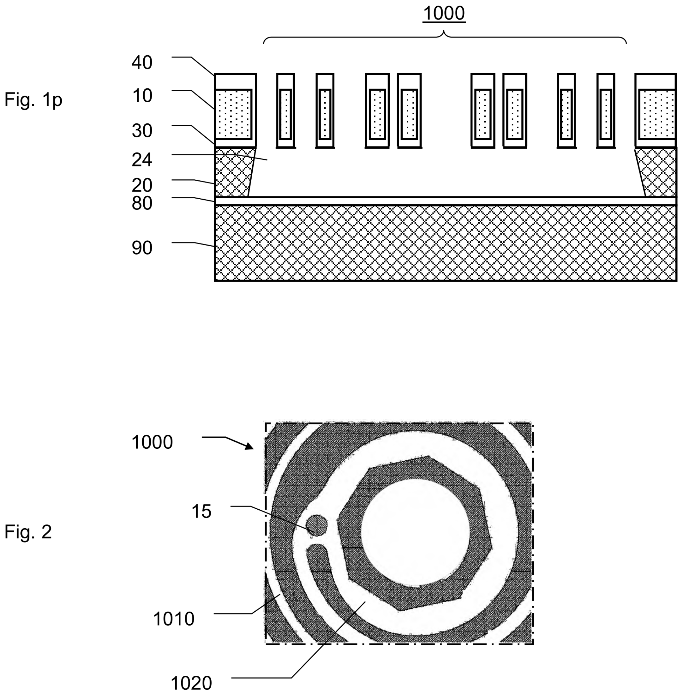

Les figures 1a à 1c, 1e à 1m et 1o illustrent une série d'étapes de fabrication schématiques d'un composant horloger dans une plaquette multicouches 100 selon un mode de réalisation de l'invention. Bien entendu, plusieurs composants horlogers peuvent être fabriqués dans la plaquette 100 en même temps, mais les vues de la figure 1 sont isolées sur un seul composant par simplicité.

Le procédé commence en se dotant d'une plaquette multicouches 100 à la figure 1a, qui est selon ce mode de réalisation illustré une plaquette de type « SOI » comprenant une couche de support 20 et une couche de travail 10, ces couches étant séparées par une couche enterrée 30 d'oxyde. Plus particulièrement, la plaquette 100 comprend la couche de travail 10 en silicium, dans laquelle les composants horlogers seront formés, et une couche de support 20 en silicium qui est séparée de la couche de travail 10 par une couche d'oxyde enterrée 30 en oxyde de silicium (SiO₂). Dans un mode de réalisation alternatif (illustré figure 1p), la plaquette 100 peut comprendre également une deuxième couche de support 90 qui peut être séparée de la couche de support 20 par une deuxième couche enterrée 80. Selon cet exemple alternatif, la deuxième couche de support 90 peut aussi être en silicium, et la deuxième couche enterrée 80 peut aussi être en oxyde de silicium (SiO₂).

Les figures ne sont pas à l'échelle mais, de préférence, l'épaisseur de la couche de travail 10 correspond généralement à l'épaisseur maximale des composants horlogers (sachant que cette épaisseur peut diminuer légèrement suite à un cycle d'oxydation-désoxydation durant le procédé de fabrication). Selon un exemple, l'épaisseur de la couche de travail 10 est d'environ 120 µm. La couche d'oxyde enterrée 30 peut avoir une épaisseur de 0.5 µm -2 µm. Avantageusement, la couche de support 20 peut avoir une épaisseur allant jusqu'à 500 µm voire 1 mm, avec de préférence une épaisseur d'au moins 150 µm.

La couche de support 20 et la couche de travail 10 peuvent être du même type de silicium ou de types différents - par exemple de silicium monocristallin avec une orientation cristalline quelconque, du silicium polycristallin, ou du silicium amorphe. Ces couches de silicium 10, 20 (et notamment la couche de travail 10) peuvent être dopés type N ou type P. Par exemple, l'utilisation d'un silicium fortement dopé peut être avantageuse pour la fabrication des résonateurs car, par exemple, on constate une déformation moindre de la matière dopée lors de l'oxydation thermique sous certaines conditions.

La plaquette multicouches 100 comprend un côté inférieur, et c'est depuis ce côté que la plaquette 100 repose normalement sur des équipements lors des différents étapes de microfabrication. La plaquette 100 comprend également un côté supérieur (voire le côté couche de travail 10), et c'est depuis ce côté que les étapes de microfabrication pour former les composants horlogers sont généralement effectuées.

Dans la figure 1b, une phase de lithographie commence avec la formation d'une couche d'oxyde de silicium 40 sur la surface supérieure de la couche de travail 10. Par « lithographie », on entend l'ensemble des opérations permettant de transférer une image ou un motif sur ou au-dessus de la plaquette 100 vers cette dernière. Dans ce mode de réalisation, la couche d'oxyde 40 a par exemple une épaisseur de 1-6 µm. La couche d'oxyde 40 peut être formée par oxydation thermique ou alternativement par un dépôt de type PVD, CVD, ou ALD. De manière générale, la formation de la couche d'oxyde 40 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche de travail 10.

A la figure 1c, la couche d'oxyde 40 est recouverte d'une couche de résine 50, qui est typiquement une résine photosensible de type positif ou négatif. Cette couche de résine peut avoir une épaisseur comprise entre 0.5 - 12 µm, à titre purement illustratif. Par la suite, dans la figure 1e, la couche de résine 50 est structurée de préférence en utilisant une étape de photolithographie avec une source de lumière ultraviolette 70 ainsi que, par exemple, un masque d'exposition 60 tel qu'un photomasque. Un système de stepper et réticule peut également être utilisé pour l'étape de photolithographie, ou alors un système d'écriture directe (i.e. sans photomasque) tel qu'un système de lithographie par laser ou par faisceau d'électrons (la lithographie e-beam). Dans l'exemple illustré, la couche 50 comprend une résine photosensible de type positif dont les parties de la résine qui sont exposées à la lumière deviennent solubles dans un révélateur et les parties non exposées 53, 52, 55, 57 restent insolubles.

A titre de comparaison, la figure 1d représente la même étape de photolithographie que la figure 1e, mais pour un composant horloger de l'art antérieur, et dans l'exemple illustré figure 1d, la couche 50 comprend aussi une résine photosensible de type positif dont les parties de la résine qui sont exposées à la lumière deviennent solubles dans un révélateur et les parties non exposées 51, 52, 55, 57 restent insolubles.

On peut noter figure 1d, que les parties centrales 51 présentent une largeur (en vue de dessus) importante, en particulier en comparaison avec les parties 52. On peut noter figure 1e que les parties centrales de résine 51 de la figure 1d sont respectivement remplacées par deux parties intermédiaires de résine 53, moins larges, et séparées par une portion de résine exposée à la lumière ultraviolette pour devenir soluble. Ainsi, comme cela sera expliqué plus en détail ci-dessous, le masque 60 de la figure 1e pour former un composant horloger selon l'invention, est différent du masque 60 de la figure 1d pour former un composant horloger selon l'art antérieur.

Dans la figure 1f, la couche de résine 50 est ouverte après avoir été développée par un révélateur, notamment un solvant qui élimine les parties exposées de la résine par voie chimique. Ensuite, à la figure 1g, les parties de la couche d'oxyde 40 qui se trouvaient en dessous des parties exposées de la résine sont aussi retirées de la surface de la couche de travail 10, et la couche d'oxyde 40 est donc structurée sur la surface de la couche de travail 10. Cette étape peut être réalisée par exemple en employant une gravure plasma sélective directionnelle utilisant un ou plusieurs gaz fluorés (tels que CHF₃, C₄F₈, et/ou SF₆) en combinaison avec au moins un des gaz He et/ou H₂ en fonction des sélectivités et des vitesses de gravure souhaitées. L'utilisation d'une technique de gravure directionnelle est généralement privilégiée lors de cette étape car elle est plus précise, mais alternativement une gravure à base de vapeur d'acide hydrofluorique (HF) ou à base d'une solution liquide tampon de type BHF peut aussi être utilisée. On peut noter figure 1g que des parties intermédiaires d'oxyde 43 sont formées en regard des parties intermédiaires de résine 53.

A l'étape illustrée à la figure 1h, la partie restante de la couche de résine 50 peut être éliminée, par exemple en utilisant un plasma dioxygène (O₂), mais optionnellement on peut garder la partie restante de cette couche comme masque en plus de la couche d'oxyde 40. Les étapes des figures 1a - 1c et 1e - 1h servent alors à former une couche en oxyde de silicium structurée 40 sur la surface supérieure de la couche de travail 10. Selon des variantes, la couche en oxyde de silicium structurée peut être formée autrement.

Ensuite, à l'étape de la figure 1i, des motifs sont gravés dans la couche de travail 10 au travers de la couche en oxyde de silicium 50 structurée, et optionnellement la couche de résine restante 50, pour former le composant horloger 1000 (ou du moins une ébauche du composant horloger 1000 indiqué figure Ij). En général, les motifs gravés s'étendent sur toute l'épaisseur de la couche de travail 10 tel qu'illustré, et à cette fin la couche d'oxyde enterrée 30 peut agir comme un stop lors de la gravure. De cette manière, l'épaisseur maximum des composants horlogers 1000 correspond généralement à l'épaisseur de la couche de travail 10. Comme illustré, à la fin de cette étape on obtient une couche de travail structurée avec des régions se trouvant autour de la structure du composant dans lesquelles le matériau de la couche de travail 10 a été éliminé, exposant ainsi des parties de la couche d'oxyde enterrée 30 en dessous de ces régions éliminées.

La gravure à l'étape de la figure 1i peut notamment être effectuée par une technique de gravure ionique réactive profonde (également connue sous l'acronyme DRIE pour « Deep Reactive Ion Etching » en anglais), par exemple en utilisant le SF₆ comme gaz réactif pour graver le silicium de la couche de travail 10 et en utilisant le gaz C₄F₈ périodiquement comme gaz de passivation pour la protection des surfaces des flancs latéraux du composant horloger. La gravure DRIE permet de former des trous et des tranchées profondes dans la couche de travail 10 avec un rapport largeur/hauteur important, ce qui est bien adapté pour des composants micromécaniques comme des composants horlogers. De manière connue, l'utilisation du gaz C₄F₈ comme gaz de passivation produit une couche de fluoropolymère sur les surfaces des flancs latéraux. Une telle couche, qui a typiquement une épaisseur de 0.1 à 5 µm, peut être enlevée des flancs par une technique appropriée par exemple en utilisant un plasma dioxygène (O₂). Alternativement, la structuration de la couche de travail 10 peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Cependant, la résolution dimensionnelle des structures gravées est généralement moins bonne avec une structuration par gravure humide/chimique qu'avec une gravure ionique réactive profonde.

Comme indiqué ci-dessus, il est également possible pour la partie restante de la couche de résine 50 d'être toujours présente lors de l'étape de gravure profonde (DRIE ou autre) de la couche de travail 10. Cette partie restante de la couche de résine peut être retirée après la gravure, et dans ce cas la couche de travail 10 est gravée au travers des deux couches 50, 40 structurées. A titre d'exemple, une résine positive peut être retirée par des solvants de type acétone ou diméthylsulfoxyde (DMSO) ou avec un plasma O₂ soit avant soit après l'étape de gravure. Pour une résine négative comme le SU-8, un plasma CF₄/O₂ peut être employé pour son retrait.

On peut noter figure 1i qu'un trou de passage 15 est gravé dans la couche de travail, délimité notamment par des parties intermédiaires 13-1 et 13-2 formées dans la couche de travail 10 en regard des parties intermédiaires d'oxyde 43. Le trou de passage 15 traverse de part en part la couche de travail 10, et pourra servir de canal de passage ou d'alimentation pour un agent de gravure lors d'une gravure ultérieure, comme cela sera expliqué. On peut enfin noter figure 1i que des parties fines 12 sont également formées dans la couche de travail 10. Si le composant horloger est un spiral horloger, alors le trou de passage 15 peut segmenter la partie centrale du spiral en formant les parties intermédiaires 13-1 et 13-2, et les partie fines 12 peuvent être des coupes du barreau formant la partie élastique en spirale.

Les figures 1k-1m et 1o illustrent l'approche de libération des composants horlogers 1000 selon ce mode de réalisation de l'invention. A la figure 1k, une couche d'oxyde 45 de silicium (SiO₂) est de préférence formée sur l'ensemble des surfaces en silicium exposées de la plaquette 10, incluant les surfaces des flancs du composant horloger. De préférence, cette couche d'oxyde 45 est formée par oxydation thermique et donc se forme également sur tout le silicium exposé de la plaquette 100 incluant la surface inférieure de la couche de support 20 si elle est en silicium, même si cela n'est pas illustré. La couche d'oxyde 45 rejoint les couches d'oxydes 40 et 30 déjà présentes sur les surfaces supérieure et inférieure (en dessous) du composant horloger, et ces dernières couches peuvent devenir légèrement plus épaisses durant l'oxydation thermique, du moins où la couche d'oxyde enterrée 30 est exposée. L'épaisseur de la couche d'oxyde 45 peut varier mais de préférence elle est comprise entre 0.05 et 2µm.

La formation de la couche d'oxyde 45 sert notamment à protéger les surfaces des flancs des composants horlogers 1000 ainsi que d'autres endroits de la plaquette où le silicium est exposé lors des étapes de fabrication suivantes du procédé. Alternativement, une couche de protection en oxyde de silicium (SiO₂) ou en un autre matériau (par exemple une résine, un polymère, ou un autre oxyde comme l'Al₂O₃) peut être sélectivement formée sur ces surfaces et notamment sur les surfaces des flancs. Un tel dépôt sélectif peut être réalisé à titre d'exemple par une technique à base de l'ALD (en anglais « atomic layer deposition ») tel que décrit dans le document Taguhi Yeghoyan, Vincent Pesce, Moustapha Jaffal, Gauthier Lefevre, Rémy Gassilloud, Nicolas Posseme, Marceline Bonvalot, Christophe Vallée; Low temperature Topographically Selective Deposition by Plasma Enhanced Atomic Layer Deposition with ion bombardment assistance. J. Vac. Sci. Technol. A 1 May 2021; 39 (3): 032416 ou le document A. Chaker, C. Vallee, V. Pesce, S. Belahcen, R. Vallat, R. Gassilloud, N. Posseme, M. Bonvalot, A. Bsiesy; Topographically selective deposition. Appl. Phys. Lett. 28 January 2019; 114 (4): 043101. D'autres techniques de dépôt sélectifs pourraient également être employées. Le dépôt sélectif d'une couche de protection peut aussi être effectué ultérieurement, après une étape de gravure directionnelle décrite ci-dessous en association avec la figure 1k. Cependant, un dépôt sélectif est généralement plus compliqué à réaliser sur les surfaces verticales des flancs des composants horlogers, et pour cette raison la formation de la couche d'oxyde 45 par oxydation thermique reste privilégiée.

Comme décrit ci-dessus, si une gravure DRIE utilisant un gaz fluoré tel que le C₄F₈ a été employée à l'étape de la figure 1i, une couche de fluoropolymère se forme généralement sur les surfaces des flancs latéraux. Selon une variante, on peut garder et ne pas enlever cette couche fluoropolymère après la gravure DRIE de cette étape de la figure 1i, et cette couche fluoropolymère peut par la suite servir comme une couche de protection de ces flancs pour les étapes qui suivent. Une telle couche de protection peut avantageusement être utilisée, par exemple, quand une gravure ultérieure de la couche de support 20 (telle que décrite ci-dessous en lien avec les figures 1l et 1m) est réalisée par une gravure en phase vapeur à base de difluorure de xénon (XeF₂), car une couche fluoropolymère est typiquement hautement sélective par rapport à cet agent de gravure.

Ensuite, à la figure 1l, une gravure qui est de préférence directionnelle, notamment de type DRIE ou ICP-RIE (« Inductively Coupled Plasma - Reactive Ion Etching » en anglais), est effectuée pour graver les couches d'oxyde 40 et 30 de la plaquette jusqu'au point auquel la couche d'oxyde enterrée 30 exposée au travers de la couche de travail 10 gravée est éliminée. Cette gravure directionnelle a lieu dans le sens vertical de la plaquette 100 depuis son côté comme illustré par les flèches dans la figure 1l et agit sur toutes les surfaces perpendiculaires au flux de gravure. Puisque dans ce mode de réalisation l'épaisseur de la couche d'oxyde 40 est plus importante que l'épaisseur de la couche d'oxyde enterrée 30, en contrôlant les paramètres et la durée de la gravure, une couche d'oxyde amincie (avec une plus faible épaisseur que la couche 40 initiale) est toujours présente sur la surface supérieure de la couche de travail structurée 10 à la fin de cette étape de gravure. La gravure étant directionnelle, les couches d'oxyde 45 sur les surfaces verticales de la couche de travail structurée, et notamment sur les surfaces des flancs des composants horlogers, sont peu exposées aux ions réactifs durant la gravure et donc sont peu, voire pas, gravées, la gravure directionnelle agissant surtout sur les couches d'oxydes 40, 30 qui sont disposées horizontalement sur la plaquette 100. Pour cette raison, la présence d'une couche de protection sur les surfaces des flancs n'est pas indispensable durant la gravure directionnelle, même si cela est privilégié. On peut noter que la gravure de cette étape est effectuée au travers du trou de passage 15 gravé dans la couche de travail 10.

Une gravure plasma sélective directionnelle utilisant au moins un gaz fluoré (tel que CHF₃, C₄F₈, et/ou SF₆) en combinaison avec au moins un des gaz He et/ou H₂ peut être employée lors de l'étape de la figure 1l en fonction des sélectivités et des vitesses de gravure voulues. Avantageusement, cette étape de gravure directionnelle peut être réalisée sans masque d'exposition rendant cette étape relativement rapide et économique. A la fin de cette étape, on obtient une couche d'oxyde enterrée ajourée avec des régions (se trouvant en dessous des régions éliminées de la couche de travail 10) dans lesquelles l'oxyde de la couche enterrée 30 a été éliminé exposant la surface supérieure de la couche de support 20.

Selon une variante, une gravure plasma sélective directionnelle à l'instar de celle effectuée à l'étape de la figure 1l peut également être effectuée avant l'étape de la figure 1j. Une telle gravure directionnelle préalable sert à enlever (ou du moins à réduire en épaisseur) les parties de la couche d'oxyde enterrée 30 se trouvant en dessous des régions éliminées de la couche de travail 10 avant l'étape d'oxydation thermique à l'étape de la figure 1k. Dans cette variante, il peut être privilégié pour la partie restante de la couche de résine 50 d'être toujours présente durant l'étape de gravure profonde de la figure 1i et cette étape de gravure directionnelle préalable afin que la couche d'oxyde 40 sur la surface supérieure de la couche de travail structurée n'est pas gravée durant la gravure directionnelle préalable. Il n'est pas nécessaire que la couche d'oxyde 40 a une épaisseur plus importante que l'épaisseur de la couche d'oxyde enterrée 30 dans ce mode de réalisation, et la couche de résine peut être enlevée après l'étape de gravure directionnelle préalable. Par la suite, on peut réaliser l'étape d'oxydation thermique de la figure 1k pour former une couche d'oxyde 45 de silicium (SiO₂) sur l'ensemble des surfaces en silicium exposées de la plaquette 100 (incluant au fond des régions éliminées de la couche de travail 10), et après une autre étape de gravure plasma sélective directionnelle à l'étape de la figure 1l a lieu comme décrit ci-dessus. L'épaisseur de l'oxyde se trouvant en dessous des régions éliminées de la couche de travail 10 qui doit être enlevée durant cette deuxième étape de gravure plasma sélective directionnelle est alors moins importante selon cette variante. Cette variante peut en outre être appliquée dans le cadre de la libération de composants horlogers fabriqués dans une plaquette SOI conventionnelle (c'est-à-dire avec juste trois couches incluant une seule couche de support) comme décrit dans la demande de brevet européen no. EP24207484 déposée au nom de la titulaire de la présente demande.

Selon une autre variante, si la couche de protection sur les surfaces des flancs comprend un matériau autre que l'oxyde de silicium (SiO₂), la gravure effectuée lors de l'étape de la figure 1l n'a pas forcément besoin d'être directionnelle, et une gravure contrôlée à base de vapeur d'acide hydrofluorique (HF) ou à base d'une solution liquide tampon de type BHF peut être utilisée à la place, afin d'ouvrir uniquement la couche enterrée en SiO₂ sans éliminer la couche d'oxyde 40.

Si une couche de protection n'a pas été formée sur les surfaces des flancs des composants horlogers avant la gravure directionnelle des couches d'oxyde 40, 30, une telle couche de protection peut être déposée sélectivement sur ces flancs après cette gravure directionnelle des couches d'oxyde 40, 30. Dans ce cas, il est important que le dépôt sélectif ne couvre pas les régions exposées de la couche de support 20 en dessous des régions éliminées de la couche d'oxyde enterrée 30.

A la figure 1m, on commence une étape de gravure du silicium de la couche de support 20 afin de la structurer en gravant une portion de cette couche de support 20 en dessous des composants horlogers. Plus particulièrement, la couche de support 20 est gravée où elle est exposée en dessous des régions éliminées de la couche d'oxyde enterrée 30. Selon la variante illustrée, une gravure humide/chimique anisotrope est utilisée à cette étape pour former des régions gravées 22 dans la couche de support 20 où le silicium a été éliminé. On peut noter que l'agent de gravure passe au travers du trou de passage 15, pour graver le silicium sous les parties intermédiaires 13-1, 13-2.

La gravure anisotrope permet d'éliminer le silicium plus rapidement dans certaines directions dans chaque région gravée 22, selon les orientations cristallines de la plaquette. Les surfaces des flancs dans les régions gravées 22 forment donc un angle et en général cet angle varie en fonction de différents paramètres incluant notamment l'orientation cristalline du silicium. Un bain d'hydroxyde de potassium (KOH) peut être utilisé pour cette gravure anisotrope, mais alternativement on peut également utiliser par exemple un bain de d'hydroxyde de tétraméthylammonium (TMAH). Selon une autre variante pour l'étape de la figure 1m, on peut utiliser une technique de gravure isotrope pour attaquer le silicium de la couche de support 20, par exemple une gravure en phase vapeur à base de difluorure de xénon (XeF₂). Une telle gravure isotrope élimine le silicium plus ou moins uniformément dans toutes les directions créant ainsi des régions gravées 22 de la couche de support ayant la forme (en section) de demi-cercles en dessous des régions éliminées de la couche d'oxyde enterrée 30.

Selon encore une autre variante particulièrement avantageuse pour attaquer le silicium de la couche de support 20 à l'étape de la figure 1m, on peut utiliser une technique de gravure isotrope avec un plasma à base d'hexafluorure de soufre (SF₆). Dans ce cas, la vitesse de réaction durant la gravure est très rapide et les surfaces gravées sont relativement propres et lisses. De plus, une telle étape peut être effectuée dans la même chambre que l'étape de gravure DRIE utilisée pour former les composants horlogers (voire l'étape de la figure 1i), notamment quand un plasma SF₆ est aussi utilisé pour cette dernière étape. Par ailleurs, durant l'attaque du silicium de la couche de support 20, des fissures peuvent apparaitre dans les couches de protection (en SiO₂ ou un autre matériau) sur les composants horlogers et notamment sur les arrêtes de ces composants. Cependant, en utilisant un plasma à base de SF₆, les radicaux fluors créés par le plasma sont très majoritairement bloqués avant de pouvoir pénétrer à l'intérieur de ces fissures, ce qui empêche toute attaque des couches de protection lors de l'étape de la figure 1m.

La figure 1n représente la plaquette de la figure 1d, pour obtenir le composant horloger 1000' de l'art antérieur. On peut noter que les parties centrales de résine 51 larges de la figure 1d ont conduit à graver des portions larges 11 dans la couche de travail 10. De la même manière que pour la figure 1m, la figure 1n représente une étape de formation de régions gravées 22 sous le composant horloger 1000'. On peut noter que les régions gravées 22 sous les portions larges 11 laissent une quantité de matière de la couche de support 20 bien plus importante que sous les autres portions plus fines du composant horloger 1000'. En comparaison avec la figure 1m où l'agent de gravure peut passer au travers du trou de passage 15, la gravure ou l'élimination complète de la matière sous tout le composant horloger 1000' et en particulier sous l'entièreté des portions larges 11, prendra plus de temps, et exposera les portions fines plus longtemps à l'environnement de gravure. Ce temps de gravure plus long peut conduire à dégrader les caractéristiques des portions fines (avec des enlèvements de matière ou des déformations intempestifs par exemple).

De préférence, et comme illustré dans la figure 1o, l'étape de gravure de la figure 1m continue afin que les régions gravées 22 dans lesquelles le silicium de la première couche de support a été éliminé s'unissent pour former une seule région éliminée formant un espace libre 24 s'étendant en dessous de chaque composant horloger 1000. La gravure peut être stoppée au moment représenté figure 1o. La présence du trou de passage 15 permet de garantir un temps de gravure plus court que pour un composant horloger dépourvu du trou de passage 15. En effet, la région gravée 22 entre les partie intermédiaires 13-1 et 13-2 peut rejoindre les autres régions gravées 22 plus rapidement que s'il n'y a pas de trou de passage dans la portion large (en référence avec les parties centrales de résine 51 larges du composant horloger de l'art antérieur de la figure 1d et les portions larges 11 de la figure 1n).

Dans un mode de réalisation alternatif de la figure 1p où la plaquette 100 comprend en plus de la couche support 20 une deuxième couche d'oxyde enterrée 80 et une deuxième couche support 90, la deuxième couche enterrée 80 (ou si elle n'est pas présente une deuxième couche de support) peut servir à arrêter la gravure de la couche de support 20 durant cette étape afin que l'espace libre 24 s'étende sur toute l'épaisseur de la couche de support 20. On obtient donc une première couche de support 20 structurée comprenant cet espace libre 24. Avantageusement, quand la couche de support 20 est relativement mince, c'est-à-dire qu'elle a une épaisseur inférieure ou égale à 50 µm (de préférence inférieure ou égale à 25 µm, et encore plus privilégiée inférieure ou égale à 10 µm), la gravure anisotrope ou isotrope des régions éliminées peut être très rapide en dessous des composants horlogers. Durant la gravure plasma ou gazeuse de la première couche de support 20 il y a généralement une quantité limitée de réactif, mais avec une couche de support 20 mince il y a moins de matière à graver dans le sens vertical de la plaquette, et la gravure a surtout lieu dans les directions latérales en dessous des composants horlogers puisque la gravure est confinée par la deuxième couche enterrée 80 (ou par une couche combinée à sa place). Cela permet de rapidement graver des régions éliminée 22 en dessous des composants horlogers en minimisant en même temps le risque de graver ou endommager la couche de protection sur les surfaces des flancs des composants. De cette manière, selon ce mode de réalisation privilégié, sensiblement toute l'épaisseur de la couche de support 20 est éliminée dans l'espace libre 24.

Selon le mode de réalisation privilégié dans lequel la réalisation de la couche d'oxyde 45 durant l'étape de la figure 1k est par une oxydation thermique, la gravure du silicium aux étapes des figures 1m et 1o attaque la couche de support 20 uniquement au travers des régions éliminées de la couche d'oxyde enterrée ajourée, les autres surfaces de la plaquette étant protégées par la couche d'oxyde 45, particulièrement la couche d'oxyde en face arrière de la plaquette.

Finalement, pour compléter la libération des composants horlogers, on peut effectuer une étape de désoxydation, ce qui élimine les couches d'oxyde 40 et 45 ainsi que les parties de la première couche d'oxyde enterrée ajourée 30 restant entre l'espace libre 24 et le ou les composants horlogers 1000 au-dessus de cette région. Cette étape de désoxydation peut être réalisée, par exemple, par une gravure par voie humide ou en phase vapeur ou gaz, par exemple à base d'acide fluorhydrique (HF) ou de gaz HF anhydre. A la fin de cette étape, on obtient donc une première couche enterrée structurée dont une partie importante de la couche a été éliminée, mais qui comprend des parties toujours présentes en dehors des zones des composants horlogers 1000. Ces parties subsistantes de ces couches d'oxyde enterrées structurée 30 gardent la liaison entre la couche de travail structurée 10 et la couche de support 20 par le biais des parties restantes de la première couche de support structurée 20.

Si la couche de protection sur les surfaces des flancs comprend un matériau autre que l'oxyde de silicium (SiO₂), cette couche de protection pourrait être enlevée ou éliminée avant ou après l'étape de la figure 1o par une technique appropriée. Par exemple, dans le cadre d'une résine ou d'une couche de fluoropolymère, on peut utiliser un plasma dioxygène (O2) pour enlever une telle couche de protection.

Les composants horlogers 1000 sont alors libérés sur la plaquette 100 permettant la réalisation des étapes de fabrication subséquentes, sur la quasi-totalité de la surface externe de ces composants. A cette fin, après la libération, les composants horlogers 1000 ne sont supportés structurellement que par des ponts de liaison (non illustrés) dans la couche de travail structurée 10. De cette manière, les composants 1000 restent attachés aux parties subsistantes de la couche de travail structurée 10.

La figure 2 représente une vue partielle de dessus d'une première variante de réalisation d'un composant horloger comprenant une portion large avec un trou de passage. Dans cet exemple particulier, le composant horloger est un spiral, et la figure 2 représente une partie centrale 1020 du spiral (que l'on peut appeler un moyeu central), avec sur la partie gauche de la partie centrale le départ du barreau 1010 en spirale. Conventionnellement à cet embranchement entre la partie centrale 1020 et le barreau 1010, la portion de silicium est plus large que pour le reste de la pièce. Afin de limiter le temps de formation de l'espace libre sous cette portion large à l'étape de la figure 1m, un trou de passage 15 est implanté à équidistance des flancs de cette portion large, pour segmenter la paroi initiale en parois intermédiaires de moindre largeur. A titre d'exemple, le trou de passage 15 peut avoir un diamètre compris entre 70 µm et 100 µm sans compromettre la chronométrie ni la résistance mécanique, et la partie centrale 1020 présente alors des parois qui ont toutes une épaisseur inférieure à 2,5 fois, de préférence 2 fois, de préférence à 1,8 fois ou 1,65 fois,1,5 fois, 1,4 fois ou 1,3 ou même 1,1 fois à celle du barreau 1010 enroulé en spirale. Aussi, tout point de la partie centrale 1020, situé sur la surface inférieure ou supérieure du spiral, est éloigné d'un bord de la partie centrale d'une distance qui n'excède pas 60 µm, alors que le barreau en spirale présente une première spire dite « épaisse » avec une épaisseur de 65 µm environ.

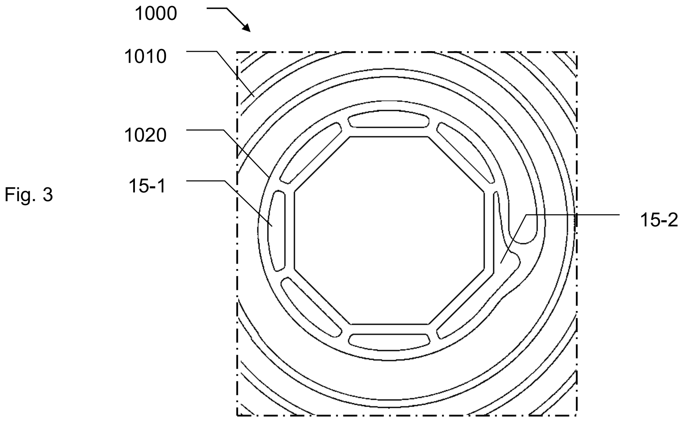

La figure 3 représente une vue partielle de dessus d'une deuxième variante de réalisation d'un composant horloger comprenant une portion large avec des trous de passage. Dans cet exemple particulier, le composant horloger est un spiral, et la figure 3 représente une partie centrale 1020 du spiral (le moyeu central) qui comprend plusieurs trous de passage 15-1 et 15-2, et le barreau 1010 enroulé en spirale. On peut noter la présence de six trous de passage 15-1 de formes similaires, et un trou de passage 15-2 d'une forme particulière. Comme pour la figure 2, la présence des trous de passage 15-1 et 15-2 permet de réduire le temps de formation de l'espace libre sous cette portion centrale large à l'étape de la figure 1m, en procurant un chemin d'accès à l'agent de gravure au travers des trous de passage.

Comme on le voir bien sur la figure 3, la partie centrale 1020 du spiral comprend un trou central octogonal, et on a sept trous de passage 15-1 et 15-2 autour de ce trou central. Chaque trou de passage 15-1 s'étend sur un peu moins de 45°, et le trou de passage 15-2 s'étend sur un peu moins de 90°.

Dans l'exemple particulier de la figure 3 toutes les parois de la partie centrale 1020 ont une épaisseur sensiblement similaire à celle du barreau 1010 enroulé en spirale. En tout état de cause, toutes les parois de la partie centrale 1020 ont une épaisseur inférieure à 2,5 fois, de préférence 2 fois, de préférence à 1,8 fois ou 1,65 fois, 1,5 fois, 1,4 fois ou 1,3 ou même 1,1 fois à celle du barreau 1010 enroulé en spirale. Par exemple, le barreau 1010 enroulé en spirale peut avoir une spire plus épaisse que les autres (par exemple la première spire), et qui présente une épaisseur de 65 µm environ. Les parois de la partie centrale 1020 ont toutes une épaisseur inférieure à 60 µm, et en particulier les parois de la partie centrale 1020 ont toutes une épaisseur inférieure à 50 µm. Aussi, tout point de la partie centrale 1020, situé sur la surface inférieure ou supérieure du spiral, est éloigné d'un bord de la partie centrale d'une distance qui n'excède pas 60 µm, alors que le spiral présente ici un barreau en spirale dont l'épaisseur est de 35 µm environ.

On peut noter la forme particulière des trous de passage 15-1 et 15-2, qui résulte d'une optimisation de la géométrie. Selon un mode de réalisation, on réalise en effet une optimisation numérique avec le but de former un trou de passage ayant la surface la plus grande possible, et qui ne modifie pas de plus d'un certain pourcentage les caractéristiques du composant horloger (la raideur et l'isochronisme par rapport au spiral sans évidement (« spiral standard »)). La résistance mécanique doit aussi être assurée, ainsi que l'intégrité de la pièce après assemblage (c'est-à-dire le « virolage » ou chassage d'une virole dans le moyeu central, l'ensemble étant ensuite chassé sur l'axe du balancier). Un ou plusieurs trous peuvent également être formés au niveau du pitonnage, c'est-à- dire à l'extrémité extérieure du spiral. On peut prévoir d'implanter un trou de passage et de définir des paramètres du trou de passage (pas d'angle vif, rayon de courbure, distance avec les flancs de la portion large, surface la plus grande possible...). On peut prévoir de vérifier par simulation numérique l'isochronisme, la raideur, les contraintes mécaniques après assemblage, la masse totale... Plusieurs itérations ou boucles de vérifications peuvent être réalisées, et une fois un modèle acceptable trouvé, on peut encore vérifier plus précisément en CAO ou avec d'autres outils que la solution peut être validée pour des pièces réelles.

Il ressort de ce qui précède, que le gain réalisé par le procédé de la présente invention se fera essentiellement en temps de fabrication par plaquette, donc sur le temps machine et à termes sur le rythme de production. Il n'y a pas de gain en performances du spiral, simplement en temps de process. Selon un exemple, la forme optimisée peut avoir des parois les plus fines possibles et/ou des trous tout autour du moyeu central (ce qui peut être bénéfique pour le chassage, et pour le procédé de fabrication).

En particulier, les trous de passage prévus selon la présente invention n'ont pas pour vocation première d'augmenter la souplesse et/ou la déformabilité de la partie centrale du spiral. il s'agit plutôt d'obtenir les parois les plus fines possible pour la partie centrale (afin de minimiser le temps de gravure) sans pour autant dégrader les performances ou les caractéristiques mécaniques du spiral.

### Application industrielle

Un procédé de fabrication selon la présente invention, et la fabrication de composants horlogers, sont susceptibles d'application industrielle.

On comprendra que diverses modifications et/ou améliorations évidentes pour l'homme du métier peuvent être apportées aux différents modes de réalisation de l'invention décrits dans la présente description sans sortir du cadre de l'invention. En particulier, le composant horloger peut être un spiral, mais aussi une roue dentée, une ancre, un composant comprenant une portion élastique comme une bascule...

## Revendications

1. Procédé de fabrication d'au moins un composant horloger (1000) en silicium dans une couche de travail (10) d'une plaquette multicouches (100), le composant horloger (1000) comprenant au moins une première portion d'une première largeur et au moins une deuxième portion d'une deuxième largeur, avec la deuxième largeur inférieure à 60%, de préférence 50%, de préférence 45% de la première largeur, le procédé de fabrication comprenant au moins les étapes consistant à :
i- graver le composant horloger (1000) dans la couche de travail (10),
ii- former un espace libre au moins en dessous de la première portion du composant horloger (1000) en gravant au moins une des autres couches de la plaquette multicouches (100),
**caractérisé :**
**en ce que** l'étape i- comprend une étape consistant à graver dans la première portion un trou de passage (15 ; 15-1, 15-2) traversant la couche de travail (10),
et **en ce que** l'étape ii- comprend l'exposition et la gravure de ladite au moins une des autres couches par un agent de gravure passant au travers du trou de passage (15 ; 15-1, 15-2),
dans lequel la présence du trou de passage (15 ; 15-1, 15-2) permet de garantir que l'étape ii- peut être totalement réalisée dans un temps strictement inférieur à un temps nécessaire pour former un espace libre sous une portion de la couche de travail (10) présentant la première largeur.

2. Procédé de fabrication selon la revendication 1, dans lequel le trou de passage (15 ; 15-1, 15-2) est non-fonctionnel une fois le composant horloger (1000) assemblé dans une pièce d'horlogerie.

3. Procédé de fabrication selon l'une des revendications 1 à 2, dans lequel la gravure du trou de passage (15 ; 15-1, 15-2) est réalisée de sorte à former au moins une troisième portion d'une troisième largeur supérieure à la deuxième largeur, et de préférence la gravure du trou de passage (15 ; 15-1, 15-2) conduit à former deux troisièmes portions d'une troisième largeur supérieure à la deuxième largeur.

4. Procédé de fabrication selon la revendication 3, dans lequel la troisième largeur est supérieure d'au moins 10% à la deuxième largeur.

5. Procédé de fabrication selon l'une des revendications 1 à 4, la plaquette multicouches (100) comprenant au moins une couche de support (20) par exemple en silicium, et une couche enterrée (30) en oxyde de silicium séparant la couche de travail (10) et la couche de support (20), dans lequel l'étape ii- comprend la gravure de la couche enterrée (30), par exemple avec une solution d'acide fluorhydrique (HF) ou de gaz HF anhydre.

6. Procédé de fabrication selon l'une des revendications 1 à 5, la plaquette multicouches (100) comprenant au moins une couche de support (20) en silicium, et une couche enterrée (30) par exemple en oxyde de silicium séparant la couche de travail (10) et la couche de support (20), dans lequel l'étape ii- comprend la gravure de la couche de support (20), avec par exemple :
- une gravure isotrope utilisant un plasma à base d'hexafluorure de soufre (SF6), ou
- une gravure isotrope en phase vapeur à base de difluorure de xénon (XeF2), ou
- une gravure humide anisotrope utilisant un bain d'hydroxyde de potassium (KOH) ou un bain de d'hydroxyde de tétraméthylammonium (TMAH).

7. Procédé de fabrication selon l'une des revendications 1 à 6, comprenant une étape intermédiaire entre les étapes i- et ii- consistant à recouvrir au moins le composant gravé avec une couche de protection, procurant une protection du composant horloger (1000) lors de la gravure de l'étape ii-.

8. Procédé de fabrication selon l'une des revendications 1 à 7, comprenant les étapes initiales consistant à :
- identifier ladite au moins une première portion et ladite au moins une deuxième portion,
- prévoir et implanter le trou de passage (15 ; 15-1, 15-2) dans la première portion.

9. Procédé de fabrication selon la revendication 8, dans lequel l'étape consistant à prévoir et implanter le trou de passage (15 ; 15-1, 15-2) comprend au moins les étapes suivantes :
- une optimisation consistant à trouver la plus grande surface possible du trou de passage (15 ; 15-1, 15-2),
- une vérification du fonctionnement d'une pièce d'horlogerie comprenant le composant horloger (1000) avec le trou de passage (15 ; 15-1, 15-2), dans une plage de fonctionnement attendue et prédéterminée.

10. Procédé de fabrication selon la revendication 9, dans lequel le composant horloger (1000) est un spiral horloger, et l'étape de vérification du fonctionnement comprend la vérification que :
- la raideur du spiral horloger, et/ou l'isochronisme de la pièce d'horlogerie comprenant le spiral horloger avec le trou de passage (15 ; 15-1, 15-2), ne varient pas au-delà d'un pourcentage prédéterminé par rapport à respectivement la raideur du spiral horloger, et/ou à l'isochronisme de la pièce d'horlogerie comprenant un spiral horloger sans le trou de passage (15 ; 15-1, 15-2),
- le spiral horloger avec le trou de passage (15 ; 15-1, 15-2) peut être accouplé à un arbre de balancier sans déformation irréversible.

11. Procédé de fabrication selon l'une des revendications 1 à 10, dans lequel la deuxième portion présente une largeur inférieure à 110 µm, de préférence 100 µm, de préférence 90 µm, de préférence 80 µm, et/ou la première portion comprend une largeur supérieure à 120 µm, de préférence 130 µm, de préférence 140 µm.

12. Procédé de fabrication selon l'une des revendications 1 à 11, dans lequel chaque première portion du composant horloger (1000) est gravée avec au moins un trou de passage (15 ; 15-1, 15-2).

13. Procédé de fabrication selon l'une des revendications 1 à 12, dans lequel :
- l'étape i- comprend au moins une étape de formation d'un masque de gravure et/ou au moins une étape de gravure ionique réactive profonde,
- l'étape i- conduit à graver au moins un pont de liaison entre le composant horloger (1000) et le reste de la couche de travail (10),
- l'étape ii- est suivie par une étape de libération du composant horloger (1000) de la couche de travail (10),
- au moins une étape d'oxydation et/ou de désoxydation du composant horloger (1000) est réalisée..

14. Spiral horloger en silicium, comprenant :
- une partie centrale (1020) avec une ouverture centrale pour se monter sur un arbre de balancier,
- un barreau formé en spirale,
- optionnellement une extrémité libre, de pitonnage ou de collage, et/ou un point d'attache au reste de la plaquette,
dans lequel la partie centrale, et l'extrémité libre, de pitonnage ou de collage,
et/ou le point d'attache au reste de la plaquette, le cas échéant, présente une première portion avec une première largeur,
- le barreau formé en spirale présente une deuxième portion avec une deuxième largeur,
la deuxième largeur est inférieure à 45% de la première largeur,
**caractérisé en ce que** la partie centrale (1020), et/ou l'extrémité libre, de pitonnage ou de collage, et/ou le point d'attache au reste de la plaquette, le cas échéant, comprend au moins un trou de passage (15 ; 15-1, 15-2) de sorte à ce que la partie centrale (1020), et/ou l'extrémité libre, de pitonnage ou de collage, et/ou le point d'attache au reste de la plaquette, le cas échéant, soit exempt de paroi d'une largeur supérieure à 2 fois, de préférence à 1,8 fois ou 1,65 fois, la deuxième largeur.
